Europäisches Patentamt

European Patent Office

Office européen des brevets

(11) Publication number: **0 308 152**
**A2**

# (12) EUROPEAN PATENT APPLICATION

(21) Application number: **88308388.3**

(22) Date of filing: **12.09.88**

(51) Int. Cl.4: **H01L 27/08 , H01L 21/82 , H01L 29/62 , H01L 29/10**

The title of the invention has been amended (Guidelines for Examination in the EPO, A-III, 7.3).

(30) Priority: **16.09.87 JP 229523/87**

(43) Date of publication of application:
**22.03.89 Bulletin 89/12**

(84) Designated Contracting States:
**DE FR GB IT**

(71) Applicant: **HITACHI, LTD.**
**6, Kanda Surugadai 4-chome**
**Chiyoda-ku Tokyo 101(JP)**

(72) Inventor: **Mitani, Shinichiroo**
**5014-2, Kamiyamaguchi**
**Tokorozawa-shi Saitama(JP)**
Inventor: **Kikushima, Kenichi**
**Hitachi-wakakusaryo 657-5, Nogami**
**Ohme-shi Tokyo(JP)**
Inventor: **Yokoyama, Goichi**
**205, Arubiyon 1920-2, Hane Hamura-cho**
**Nishitama-gun Tokyo(JP)**

(74) Representative: **Stuart, Ian Alexander et al**
**MEWBURN ELLIS & CO. 2/3 Cursitor Street**
**London EC4A 1BQ(GB)**

(54) **MIS integrated circuit device and method of manufacturing the same.**

(57) The gate electrodes 8 of a P-channel MISFET and an N-channel MISFET are made of a P-type polycrystalline silicon film or a poly-cide film utilizing a P-type polycrystalline silicon film, and very shallow diffused layers 7 formed as As or Sb are provided in the channel portions of the MISFETs, thereby to control the threshold voltages of the MISFETs. Thus, in both the P-channel MISFET and the N-channel MISFET, punch-through and fluctuations in the threshold voltages are reduced and hence short channels of the MISFETs can be attained.

EP 0 308 152 A2

FIG. 7

# SEMICONDUCTOR INTEGRATED CIRCUIT DEVICE AND METHOD OF MANUFACTURING THE SAME

The present invention relates to a semiconductor integrated circuit device and a method of manufacturing the same. More particularly, it relates to a technique which is effective when applied to the microfabrication of a MISFET.

The threshold voltage of a MISFET of the enhancement mode has been controlled by introducing a P-type impurity, namely, boron into a channel region, in both a P-channel MISFET and an N-channel MISFET. The reason is that an $N^+$-type polycrystalline silicon film being lower in resistance than a $P^+$-type polycrystalline silicon film has been employed as the material of a gate electrode. When the gate electrode is made of the $N^+$-type polycrystalline silicon film, the threshold voltage becomes low in the N-channel MISFET, and it becomes high in the P-channel MISFET. Therefore, the threshold voltage of each of the P-channel and N-channel MISFETs has been rendered about 0.6 V by introducing boron into the channel region thereof.

In an N-type well region where the P-channel MISFET to which such a technique is applied is constructed, a P-N junction is defined in the deep part (about 0.2 μm deep) of the channel region. This is ascribable to the fact that, since the diffusion coefficient of boron is great, the boron introduced into the channel region diffuses deep into a substrate. Here, a depletion layer from the drain region of the MISFET spreads in the deep part of the substrate more than in the surface thereof. When the P-N junction is formed in the deep part of the channel region as stated above, the depletion layer from the drain region has its spread promoted by this P-N junction and comes to exert influence on the edge of a depletion layer from the source region of the MISFET. Therefore, when the reduction of a channel length has been attained, the threshold voltage becomes different from a design value, or punch-through arises across the source region and the drain region. It is accordingly impossible to reduce the channel length of the MISFET, that is, to achieve a short channel.

By the way, a technique for shortening a channel is described in "IEDM Technical Digest," 1986, pp. 252 - 255.

The aforementioned technique for shortening the channels of a CMOS device consists in that the gate electrode of a P-channel MISFET is formed of poly-cide utilizing a $P^+$-type polycrystalline silicon film, while the gate electrode of an N-channel MISFET is formed of poly-cide utilizing an $N^+$-type polycrystalline silicon film. The respective gate electrodes of the N-channel and P-channel MISFETs are formed by patterning the poly-cides which have been formed in such a way that N-type and P-type impurities are introduced into the selected parts of polycrystalline silicon deposited on the whole surface of a substrate and are activated, whereupon $TaSi_2$ is deposited on the polycrystalline silicon. However, when the gate electrodes of both the N- and P-channel MISFETs are formed to be unitary in this manner, interdiffusion of the impurities develops between the $P^+$-type polycrystalline silicon film and the $N^+$-type polycrystalline silicon film due to annealing carried out in the process of manufacture, and the threshold voltages of the MISFETs to be formed become unstable due to fluctuations in the difference between the work functions of the gate electrodes and the substrate. For the purpose of preventing this drawback, a device needs to be manufactured by annealing at or below about 800°C. Annealing at such a low temperature, however, incurs the problem that the formation of diffused layers and insulator films becomes difficult. Moreover, in a device wherein the gate electrodes of a P-channel MISFET and an N-channel MISFET are separated, wiring for connecting these gate electrodes is required, which is problematic when there is a high density of integration.

It is desirable to achieve the microfabrication of a MISFET.

It is also desirable to provide a semiconductor device and a method of manufacturing the same, which can produce a CMOS device of good "threshold voltage - channel length" characteristics without spoiling the high operating speed and the high integration density of the CMOS device.

The above and other desiderata that may be achievable by embodiments of the present invention will become more apparent from the description of this specification and the accompanying drawings.

A typical aspect of performance of the present invention is briefly summarized as follows:

Each of the threshold voltages of an N-channel MISFET and a P-channel MISFET is controlled by the N-type impurity of a channel region, for example, As or Sb and the $P^+$-type polycrystalline silicon film of a gate electrode.

According to the expedient described above, owing to the use of the N-type impurity As or Sb as an impurity for adjusting the threshold voltage, in the P-channel MISFET, a P-N junction is not formed in the channel region thereof, and hence, the spread of a depletion layer from the drain region of the MISFET is not promoted. In the N-channel MISFET, even when a P-N junction is formed in the channel region thereof, the depth of the junction is as very small as approximately 0.05 $\mu$m from the surface of a substrate, so that the part of the depletion layer from the drain region of the MISFET having a great spread is not further enlarged. In both the P-channel MISFET and the N-channel MISFET, accordingly, the fluctuations of the threshold voltages and punch-through become difficult to occur, and hence, the short channels of the MISFETs can be realized. Moreover, since the gate electrodes are made of polycrystalline silicon of the same conductivity type in both the P-channel and N-channel MISFETs, the impurity interdiffusion between both the gates can be prevented during the process of manufacture, and a CMOS device of high reliability can be produced.

## BRIEF DESCRIPTION OF THE DRAWINGS

Figs. 1 to 8 are processing sectional views showing an embodiment of a method of manufacturing a CMOS device to which the present invention is applied; and

Fig. 9 is an enlarged sectional view of the channel region portions of a P-channel MISFET and an N-channel MISFET.

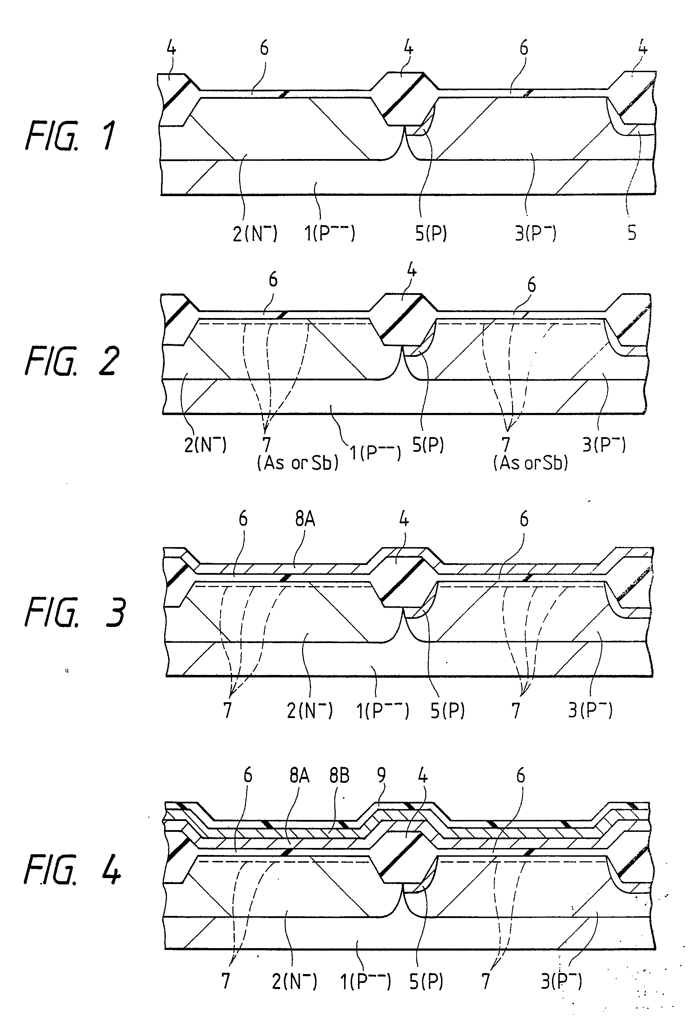

Figs. 1 to 8 illustrate an embodiment in which the present invention is applied to a CMOS device.

First, as shown in Fig. 1, an $N^-$-type well region 2, a $P^-$-type well region 3, a field insulator film 4 and a P-type channel stopper 5 are respectively formed in or on a semiconductor substrate 1 made of $P^{---}$-type single-crystal silicon by well-known processes. The $N^-$-type well region 2 is formed by the drive-in diffusion of ion-implanted phosphorus or arsenic, while the $P^-$-type well region 3 is formed by the drive-in diffusion of ion-implanted boron. The impurity concentration of each of the $N^-$-type well region 2 and the $P^-$-type well region 3 is approximately $2 \times 10^{16}$ atoms/cm$^3$. Further, as shown in Fig. 1, the field insulator film 4 is formed by the thermal oxidation of the substrate 1 so as to define regions where elements are to be formed. A gate insulator film 6 which is about 15nm thick is formed on each of the element forming regions by the thermal oxidation of the substrate 1.

Subsequently, as shown in Fig. 2, an N-type impurity, for example, As 7 or Sb 7 for adjusting the threshold voltages of both a P-channel MISFET and an N-channel MISFET is introduced into the surface of the substrate 1 by ion implantation at 60 keV and $5 \times 10^{11}$ atoms/cm$^2$. Here, diffusion coefficients are Sb $\ll$ As $\ll$ B. By employing Sb or As for the adjustments of the threshold voltages, accordingly, a P-N junction to be defined between the impurity and the $P^-$-type well region 3 can be formed shallow to the extent of 0.05 $\mu$m.

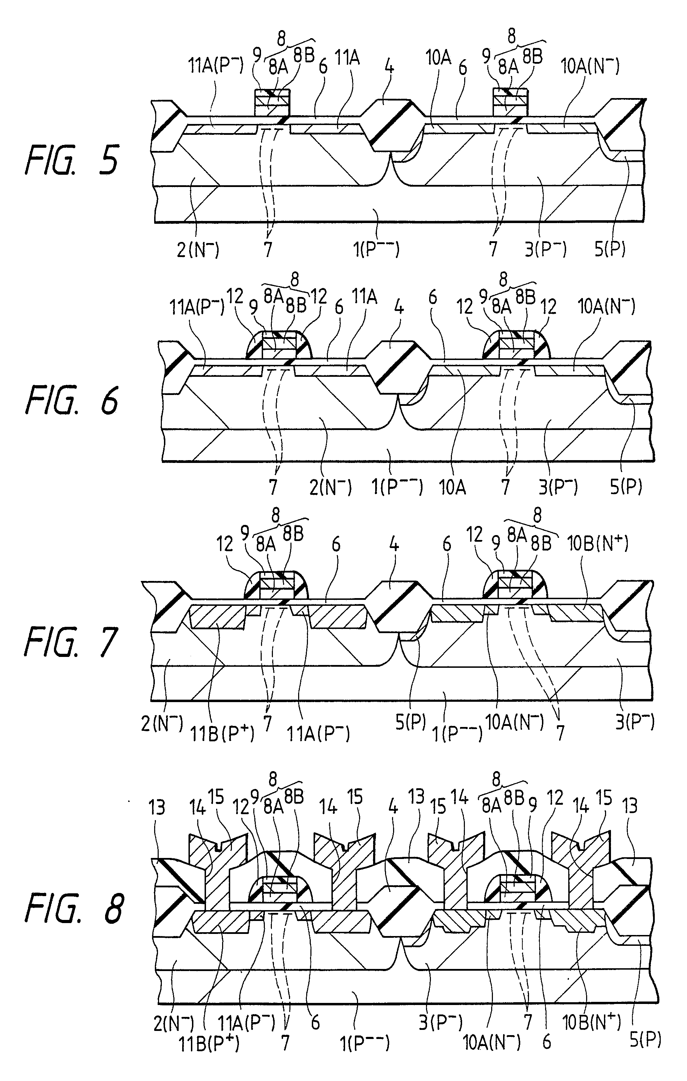

Next, as shown in Fig. 3, a polycrystalline silicon film 8A to constitute gate electrodes 8 is formed on the gate insulator films 6 overlying the substrate 1 to a thickness of about 200 nm by, for example, plasma CVD. Also, a P-type impurity, for example, boron is introduced into the polycrystalline silicon film 8A at 10 keV and $2 \times 10^{15}$ atoms/cm$^2$ so as to turn this film into the $P^+$-type.

Next, as shown in Fig. 4, a WSi$_2$ film 8B to constitute the gate electrodes 8 is formed on the polycrystalline silicon film 8A to a thickness of about 200 nm by, for example, CVD. Incidentally, the WSi$_2$ film 8B may well be a film of a refractory metal such as W, Mo, Ta, Ti or Pd or a film of any silicide of the refractory metal. After the WSi$_2$ film 8B has been formed, a silicon oxide film 9 is further formed thereon at a thickness of about 80 nm by, for example, CVD. The silicon oxide film 9 serves to prevent As from entering the gate electrodes 8 at the ion implantation of the As which is performed later in order to form the source and drain regions of the N-channel MISFET Accordingly, this silicon oxide film is not especially required if the concentration of the boron in the $P^+$-type polycrystalline silicon. film 8A is high to the extent that this film 8A is not inverted into the N-type by the ion implantation at the step of forming the source and drain regions of the N-channel MISFET.

Next, as shown in Fig. 5, the silicon oxide film 9, WSi$_2$ film 8B and $P^+$-type polycrystalline silicon film 8A are successively etched by etching which uses a mask made of a resist film not shown. Each of the gate electrodes 8 is made of a double-layer film which consists of the $P^+$-type polycrystalline silicon film 8A and the WSi$_2$ film 8B. After the etching, the mask made of the resist film is removed. Subsequently, a P-channel MISFET region (a region other than a region for forming the N-channel MISFET) is covered with a mask made of a resist film not shown, whereupon using the silicon oxide film 9 and the gate electrode 8 as a mask, P (phosphorus) is introduced into the N-channel MISFET forming region at, for example, 60 keV and $1 \times 10^{13}$ atoms/cm$^2$, thereby to form shallow ion-implanted layers of low impurity concentration 10A which constitute the source and drain regions of the N-channel MISFET. After the ion implantation, the mask made of the resist film is removed. Subsequently, a mask made of a resist film and covering the N-channel MISFET region is formed anew, and using the silicon oxide film 9 and the gate electrode 8 as a mask, boron is introduced into the P-channel MISFET forming region at, for example, 40 keV and $1 \times 10^{13}$ atoms/cm$^2$, thereby to form shallow ion-implanted layers of low impurity concentration 11A which constitute the source and drain regions of the P-channel MISFET After the ion implantation, the mask made of the resist film is removed. Thereafter, the resultant substrate is annealed at about 900°C to activate all of the impurity 7 for controlling the threshold voltages, the impurity of the N⁻-type regions 10A and the impurity of the P⁻-type regions 11A. On this occasion, the impurity 7 is hardly driven into the substrate 1 because the diffusion coefficient thereof is very small.

Next, as shown in Fig. 6, a silicon oxide film having a thickness of about 400nm is formed on the whole surface of the substrate 1 by, for example, CVD, and it is etched back by reactive ion etching (RIE), thereby to form side walls 12 on both side surfaces of the gate electrodes 8. The length of each side wall 12 in the channel length direction of the MOSFET is about 300nm.

Next, as shown in Fig. 7, the P-channel MISFET region (on the N-type well 2) is covered with a mask made of a resist film not shown, and As is introduced into the N-channel MISFET forming region at 80 keV and approximately $5 \times 10^{15}$ atoms/cm² by ion implantation employing the gate electrode 8, silicon oxide film 9 and side walls 12 as a mask, thereby to form deep ion-implanted layers of high impurity concentration 10B which constitute the source and drain regions of the N-channel MISFET. After the ion implantation, the mask made of the resist film is removed. Subsequently, a mask made of a resist film and covering the N-channel MISFET region (the region other than the N-type well) is formed anew, and B (boron) is introduced into the P-channel MISFET region at 10 keV and approximately $2 \times 10^{15}$ atoms/cm² by ion implantation employing the gate electrode 8, silicon oxide film 9 and side walls 12 as a mask, thereby to form deep ion-implanted layers of high impurity concentration 11B which constitute the source and drain regions of the P-channel MISFET. After the ion implantation, the mask made of the resist film is removed. Thereafter, the N⁺-type regions 10B and the P⁻-type regions 11B are activated by annealing at about 950°C. On this occasion, the N-type impurity 7 for adjusting the threshold voltages spreads into the substrate 1 very little because the diffusion coefficient thereof is very small.

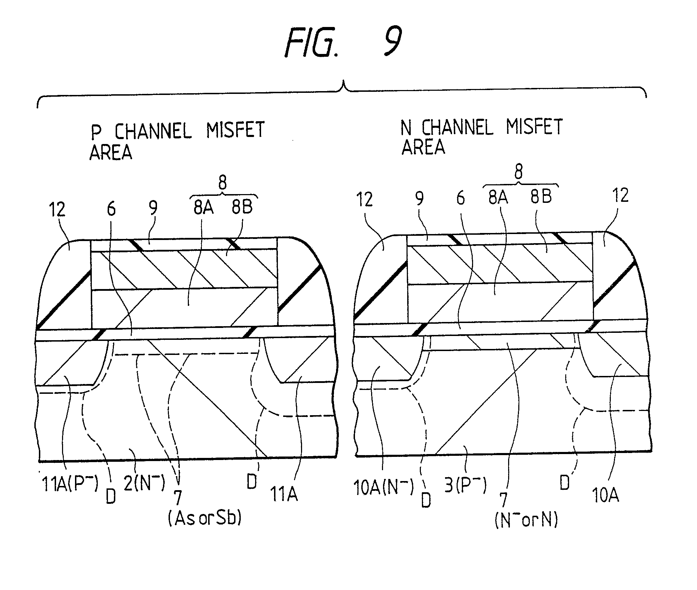

At the next step, as shown in Fig. 8, there are formed an inter-layer insulator film 13 in which a phosphosilicate glass (PSG) film is stacked on a silicon oxide film deposited by, for example, plasma CVD; contact holes 14; and wiring 15 which comprises an aluminum film deposited by, for example, sputtering.

Here, the respective channel regions of the P-channel MISFET and the N-channel MISFET are shown on enlarged scale in Fig. 9.

Referring to Fig. 9, a depletion layer spreading from each of the N⁻-type regions 10A or the P⁻-type regions 11A is illustrated in model fashion at letter D. It is assumed in Fig. 9 that the N⁻-type region 10A and the P⁻-type region 11A on the right sides are the drain regions, while the N⁻-type region 10A and the P⁻-type region 11A on the left sides are the source regions.

In the present invention, the N-type impurity As or Sb is used as the impurity 7 for adjusting the threshold voltages. In the N-channel MISFET region, therefore, the depth of the junction formed between the P⁻-type well region 3 and the N⁻- or N-type region 7 by the impurity 7 becomes about 0.05 $\mu$m, which is very small as compared with the depth of a junction in the case of using the P-type impurity of boron as an impurity for adjusting threshold voltages. For this reason, the junction part between the region 7 and the well region 3 does not further enlarge that part of the depletion layer of the drain region which is greatly spread. Accordingly, neither the punch-through between the source and the drain nor the change of the threshold voltage takes place. On the other hand, in the P-channel MISFET, the N⁻-type well region 2 and the impurity 7 for adjusting the threshold voltage have the same conductivity type, so that a P-N junction is not defined in the channel region, and the spread of the depletion layer of the drain region is not promoted.

Here, as is well known, the threshold voltage $V_{th}$ is expressed by:

$$V_{th} - \emptyset_{MS} = 2\ \emptyset_F + \frac{Q_B}{C_{OX}}$$

$\emptyset_{MS}$    Difference between the work functions of the gate electrode and the substrate (silicon)
$\emptyset_F$    Fermi level of silicon
$Q_B$    Quantity of charges in the substrate
$C_{OX}$    Capacitance of the gate oxide film

The impurity concentrations of the N⁻-type well region 2 and the P⁻-type well region 3 in this embodiment are both $2 \times 10^{16}$ atoms/cm³, and the work function differences $\emptyset_{MS}$ between them and the P⁺-type polycrystalline silicon film 8A are 0.92 eV and 0.18 eV, respectively. In addition, the values $2\ \emptyset_F$ of the N⁻-type well region 2 and the P⁻-type well region 3 are -0.74 eV and 0.74 eV, respectively. Besides, the value $Q_B/C_{OX}$ of the N⁻-type well region 2 is -0.37 V, and that of the P⁻-type well region 3 is 0.37 V. When calculated by substituting these values into the above expression, the threshold voltage of the P-channel MISFET without the introduction of the impurity into the channel region becomes -0.19 V, and the similar threshold voltage of the N-channel MISFET becomes 1.29 V.

Accordingly, an N-channel MISFET of the enhancement mode having a threshold voltage of about 0.6 V can be fabricated by forming the $N^-$- or N-type region 7 in the channel region of the N-channel MISFET which has the gate electrode 8 including the $P^+$-type polycrystalline silicon film as a part thereof. That is, the $P^+$-type polycrystalline silicon film 8A is used as a part of the gate electrode 8 in order that the N-channel MISFET having the $N^-$-type region 7 or N-type region 7 in the channel region may be rendered the enhancement mode, whereby an enhancement-mode N-channel MISFET having a threshold voltage of about 0.6 V can be fabricated. On the other hand, in the P-channel MISFET, the threshold voltage is made too high merely by introducing the N-type impurity 7 into the channel region, and hence, the $P^+$-type polycrystalline silicon film 8A is used as a part of the gate electrode 8, whereby an enhancement-mode P-channel MISFET having a threshold voltage of about -0.6 V can be fabricated.

By the way, although the plan pattern thereof is not depicted, the N-channel MISFET and P-channel MISFET are used as, for example, elements which constitute the basic cell of a gate array. In this case, even when the gate electrode 8 of the N-channel MISFET and that of the P-channel MISFET are formed to be unitary, the interdiffusion of the impurities does not take place because both the members of the polycrystalline silicon film 8A constituting the gate electrodes are of the $P^+$-type. That is, the threshold voltages do not fluctuate due to the interdiffusion of the impurities contained in the gate electrodes 8.

Effects which are produced by typical aspects of performance of the present invention will be briefly explained below:

A threshold voltage is controlled by the N-type impurity, for example, As or Sb of a channel region and the $P^+$-type polycrystalline silicon film of a gate electrode, whereby in a P-channel MISFET, a P-N junction is not formed in the channel region, so that the spread of a depletion layer from a drain region is not promoted, and in an N-channel MISFET, even when a P-N junction is formed in the channel region, the depth thereof is as very small as about 0.05 μm from the surface of a substrate, so that the part of the depletion layer of a drain region having a great spread is not further enlarged. Accordingly, the fluctuations of the threshold voltages and punch-through become difficult to occur in both the P-channel MISFET and the N-channel MISFET, so that the short channels of the MISFETs can be attained.

Moreover, the gate electrodes of the N-channel MISFET and the P-channel MISFET are both made of a poly-cide utilizing $P^+$-type polycrystalline silicon, so that the problem of the inerdiffusion of impurities between the gate electrodes of the N-channel MISFET and the P-channel MISFET does not occur in the process of manufacture. In consequence, an identical gate electrode can be shared by the P-channel and N-channel MISFETs, and a CMOS device suited to a high density of integration can be realized.

Although, in the above, the present invention has been concretely described in conjunction with the embodiments, it is needless to say that the present invention is not restricted to the foregoing embodiments, but that it can be variously altered within a scope not departing from the purport thereof.

By way of example, the structure of the source or drain of a MISFET may be constructed only of a deep ion-implanted layer, or that of the drain may well be a DDD (Double Doped Drain) structure which is constructed of a diffused layer of low impurity concentration and a diffused layer of high impurity concentration. In addition, the material of a gate is not restricted to P-type polycrystalline silicon or a poly-cide utilizing P-type polycrystalline silicon, but it may be any material with which a plus work function difference is afforded relative to a semiconductor substrate.

## Claims

1. A semiconductor device comprising:
a semiconductor substrate (1) of first conductivity type; and
MISFETs formed on said semiconductor substrate, each of the MISFETs being provided with:
a gate electrode (8) which includes a $P^+$-type polycrystalline silicon film;
first semiconductor regions of second conductivity type opposite to the first conductivity type, which are formed in said semiconductor substrate (1) and which are source and drain regions, respectively, and a second semiconductor region (7) which is formed by introducing an N-type impurity into a part of said semiconductor substrate under said gate electrode and which is shallower than said first semiconductor region;
wherein a threshold voltage of said each MISFET is controlled by said polycrystalline silicon film and the N-type impurity which forms said second semiconductor region (7).

2. A semiconductor device according to claim 1, wherein each of said first semiconductor regions (10,11) is constructed of a third semiconductor region (10B,11B) which is formed so as to be spaced from said gate electrode (8), and a fourth semiconductor region (10A,11A) which is formed between said gate electrode (8) and said third semiconductor region (10B,11B) and which is shallower than said third semiconductor region (10B,11B) and has an impurity concentration lower than that of said third semiconductor region (10B,11B).

3. A semiconductor device according to claim 1 or claim 2, wherein each of said MISFETs is further provided with side walls (12) which are formed on sides of said gate electrode (8), and the third semiconductor regions (10B,11B) are respectively spaced from said gate electrode by said side walls (12).

4. A semiconductor device according to any one of the preceding claims. wherein the N-type impurity is selected from the group consisting of As and Sb.

5. A semiconductor device according to any one of the preceding claims, wherein said gate electrode (8) is constructed of a double-layer film in which said $P^+$-type polycrystalline silicon film (8A) is overlaid with a film (8B) of any refractory metal such as Mo, W, Ti, Ta and Pd, or a film of a silicide of such a refractory metal.

6. A semiconductor device according to any one of the preceding claims, wherein the first conductivity type is P-type.

7. A semiconductor device according to any one of claims 1 to 5, wherein the first conductivity type is N-type.

8. A semiconductor device comprising:
a semiconductor substrate (1) of first conductivity type;
a well region (2) of the first conductivity type and a well region (3) of second conductivity type, which are formed in said semiconductor substrate (1); and
first and second groups of at least one MISFET which are formed on said semiconductor substrate, and each MISFET of which is provided with a gate electrode (8) which includes a $P^+$-type polycrystalline silicon film, semiconductor regions (10,11) which are source and drain regions formed in said semiconductor substrate (1), respectively, and a first semiconductor region (7) which is formed by introducing an N-type impurity into a part of said semiconductor substrate (1) under said gate electrode (8), the N-type impurity of said first semiconductor region controlling the threshold voltages of each of the MISFETs conjointly with said $P^+$-type polycrystalline silicon film, the first and second groups of said MISFETs being respectively formed in said well region (2) of the first conductivity type and said well region (3) of the second conductivity type;
wherein one of the first and second groups consists of P-channel MISFETs, said semiconductor regions (11) of each of which are second semiconductor regions of P-type, and wherein the other of the first and second groups consists of N-channel MISFETs, said semiconductor regions (10) of each of which are third semiconductor regions of N-type.

9. A semiconductor device according to claim 8, wherein the N-type impurity is selected from the group consisting of As and Sb.

10. A semiconductor device according to claim 8 or claim 9, wherein said gate electrode (8) is constructed of a double-layer film in which said $P^+$-type polycrystalline silicon film (8A) is overlaid with a film (8B) of any of refractory metals such as Mo, W, Ti, Ta and Pd, or a film of a silicide of such a refractory metal.

11. A semiconductor device according to any one of claims 8 to 10, wherein said each second semiconductor region (10) is constructed of a fourth semiconductor region (10B) which is formed so as to be spaced from said gate electrode (8), and a fifth semiconductor region (10A) which is formed between said gate electrode (8) and said fourth semiconductor region (10B) and which is shallower than said fourth semiconductor region (10B) and has an impurity concentration lower than that of said fourth semiconductor region (10B).

12. A semiconductor device according to any of claims 8 to 11, wherein said each third semiconductor region (11) is constructed of a sixth semiconductor region (11B) which is formed so as to be spaced from said gate electrode (8), and a seventh semiconductor region (11A) which is formed between said gate electrode (8) and said sixth semiconductor region (11B) and which is shallower than said sixth semiconductor region (11B) and has an impurity concentration lower than that of said sixth semiconductor region (11B).

13. A semiconductor device according to claim 12 as appendant on claim 11, wherein each of the MISFETs is further provided with side walls (12) which are formed on sides of said gate electrode (8), and the fourth (10B) and sixth (11B) semiconductor regions are respectively spaced from the gate electrodes (8) by said side walls (12).

14. A method of manufacturing a semiconductor device having N-channel MISFETs and P-channel MISFETs which are formed in a semiconductor substrate (1) of first conductivity type, one of the N-channel and P-channel MISFETs being formed within a well region (2,3) of the first conductivity type formed in the semiconductor substrate and the other of them being formed within a well region (3,2) of second conductivity type formed in the semiconductor substrate comprising:

(a) the step of introducing an impurity of N-type into parts of a principal surface of said semiconductor substrate (1) for forming said N-channel and P-channel MISFETs, thereby to form first regions (7);

(b) the step of depositing a polycrystalline silicon film (8A) for forming gate electrodes (8) of the respective MISFETs;

(c) the step of introducing an impurity of P-type into said polycrystalline silicon film;

(d) the step of depositing a film (8B) on the polycrystalline silicon into which the P-type impurity has been introduced, said film being a refractory metal film or a refractory metal silicide film, and then etching said films with photoresist masks, thereby to form said gate electrodes (8), each gate electrode (8) having two sides;

(e) the step of introducing an impurity of the N-type into the region for forming said N-channel MISFETs, with said gate electrodes (8) as a mask, thereby to form second regions (10A);

(f) the step of introducing an impurity of the P-type into the first region (7) for forming said P-channel MISFETs, with said gate electrodes (8) as a mask, thereby to form third regions (11A);

(g) the step of forming side walls (12) on the respective sides of said each gate electrode (8);

(h) the step of introducing an impurity of the N-type into the region for forming said N-channel MISFETs, with said gate electrodes (8) and said side walls (12) as a mask, thereby to form fourth regions (10B), the fourth regions (10B) being deeper than the second regions (10A) and having an impurity concentration higher than that of the second regions (10A) so as to construct source and drain regions of said N-channel MISFETs conjointly with said second regions (10A); and

(i) the step of introducing an impurity of the P-type into the region for forming said P-channel MISFETs, with said gate electrodes (8) and said side walls (12) as a mask, thereby to form fifth regions (11B), the fifth regions (11B) being deeper than the third regions (11A) and having an impurity concentration higher than that of the third regions (11A) so as to construct source and drain regions of said P-channel MISFETs conjointly with said third regions (11A).

15. A method of manufacturing a semiconductor device according to claim 14, wherein the N-type impurity for forming the first regions (7) is As or Sb, and said first regions (7) are formed by ion-implanting said N-type impurity under conditions of 60 KeV and $5 \times 10^{11}$ atoms/cm$^2$.

16. A method of manufacturing a semiconductor device according to claim 14 or claim 15, wherein the P-type impurity which is introduced into said polycrystalline silicon film (8A) is boron.

17. A method of manufacturing a semiconductor device according to any one of claims 14 to 16, wherein the N-type impurity for forming the fourth regions (10B) is As, and said fourth regions (10B) are formed by ion-implanting said N-type impurity under conditions of 80 KeV and $5 \times 10^{15}$ atoms/cm$^2$.

18. A method of manufacturing a semiconductor device according to any one of claims 14 to 17, wherein the P-type impurity for forming said fifth regions (11B) is boron.

FIG. 1

2(N⁻)  1(P⁻⁻)  5(P)  3(P⁻)  5

FIG. 2

2(N⁻)  7
(As or Sb)  1(P⁻⁻)  5(P)  7
(As or Sb)  3(P⁻)

FIG. 3

7  2(N⁻)  1(P⁻⁻)  5(P)  7  3(P⁻)

FIG. 4

7  2(N⁻)  1(P⁻⁻)  5(P)  7  3(P⁻)

FIG. 5

FIG. 6

FIG. 7

FIG. 8

# FIG. 9

P CHANNEL MISFET AREA

N CHANNEL MISFET AREA

11A(P⁻)  2(N⁻)  7 (As or Sb)  11A

10A(N⁻)  3(P⁻)  7 (N⁻or N)  10A